# EUROPEAN PATENT SPECIFICATION

(11) **EP 0 219 254 B1**
(45) Date of publication and mention of the grant of the patent: **15.11.1995**
(21) Application number: 86307428.2
(22) Date of filing: 26.09.1986
(51) Int. Cl.: C04B 37/02, H01L 21/48

(54) **Joined ceramic-metal composite**
Keramik-Metall-Verbund
Matériau céramique-métal

(30) Priority: 26.09.1985 JP 211056/85
(43) Date of publication of application: 22.04.1987
(73) Proprietor: KABUSHIKI KAISHA TOSHIBA, Kawasaki-shi, Kanagawa-ken 210 (JP)
(72) Inventor: Matsumura, Kazuo Patent Division, Minato-ku Tokyo (JP); Nagata, Mitsuhiro Patent Division, Minato-ku Tokyo (JP); Tanaka, Tadashi Patent Division, Minato-ku Tokyo (JP)
(74) Representative: Freed, Arthur Woolf

(56) References cited:
- EP-A- 0 049 007
- DE-A- 3 324 661
- GB-A- 2 099 742
- US-A- 4 409 278
- US-A- 4 409 278
- US-A- 4 413 766
- Declaration of Kazuo Matsumara of 24th July 1990.

## Description

This invention relates to a method of forming a joined ceramic-metal composite having a copper sheet directly joined to a ceramic substrate.

In recent years, there have been developments in ceramic circuit boards which are intended for substrates in transistor modules, for example the so-called DBC substrates. These DBC substrates are obtained by disposing a copper sheet destined to form conductor circuits at a stated position on a ceramic substrate and joining them directly by heating to a temperature not exceeding the melting point of copper (1,083°C) but exceeding the eutectic point of copper and oxygen (1,065°C). In the DBC substrates, the ceramic substrate is easily warped or deformed during application of heat for the purpose of union and, consequently, any gas emanating from the ceramic substrate or copper sheet will become entrapped in the interface between the ceramic substrate and the copper sheet. Thus, the copper sheet will sustain fine blisters in part thereof which gives rise to portions of insufficient union in the produced composites. When these blisters grow to a size exceeding a certain level, they become a problem in that the DBC substrates will not permit silicon semiconductor chips to be mounted easily thereon and consequently the yield of the products will be poor. There is another problem in that, even when the chips are mounted the chips may have poor adhesion and may suffer from inferior thermal conductivity.

An object of this invention is to substantially alleviate such problems as described above. Another object of this invention is to provide a joined ceramic-metal composite which alleviates blisters being produced and thereby provides an improved yield.

We acknowledge the disclosure in US-A-4 413 766 of a method of forming a conductor pattern including fine conductor runs on a ceramic substrate, having the features defined in the pre-characterizing portion of Claim 1 below. Grooves can be machined or embossed into the bottom of a metallic sheet at the interface with a ceramic substrate, to serve as vent passages for any entrapped gas.

The present invention is directed to a method of forming a joined ceramic-metal composite which comprises a ceramic substrate (1) and a copper sheet (2) joined to one or each of the major surfaces of said ceramic substrate (1), said method comprising:
forming a plurality of grooves (3) in at least one major surface of said copper sheet for contacting one of the major surfaces of said ceramic substrate (1),
superposing the grooved major surface of said copper sheet (2) on one of the major surfaces of said ceramic substrate (1);
heating the superposed layers so as to directly join said ceramic substrate (1) to said copper sheet (2) by enabling any gas emanating from said ceramic substrate (1) or said copper sheet (2) to be vented by said grooves; and
cooling the hot composite consequently formed;
characterized by the steps, prior to the said superposition of the copper sheet on the substrate, of forming the grooves (3) by pressing edges of blades against said copper sheet (2); and specular polishing and then whet honing said ceramic substrate (1) to ensure said ceramic substrate (1) has a warp of no more than 20µ/50mm;
and in that the heating is at a temperature in the range of 1065° to 1083°C.

As examples of ceramic substrates which may be used in the present invention, there can be cited substrates of oxide type ceramics such as alumina and beryllium oxide and substrates of non-oxide type ceramics such as aluminium nitride and silicon nitride. When a non-oxide type ceramic substrate is used, it is desirable that the surface of the substrate to be joined should be given an oxidizing treatment in advance of the union to ensure fastness of the union. To preclude the occurrence of blisters, the warp possibly inflicted on the ceramic substrate is desired to be not more than 20µ/50mm. To ensure this preclusion, it is desirable that the ceramic substrate to be used should be given a specular polishing and then a whet honing in advance of the union.

The copper sheet to be used is desired to be made of oxygen-free copper or tough pitch copper having an oxygen content in the range of 100 to 2,000 ppm, preferably 200 to 500 ppm. The practical thickness of the copper sheet is in the range of 0.03 to 0.5 mm.

In the present invention, grooves are formed on the surface of the copper sheet which is to be joined to the ceramic substrate so that the oxygen which emanates from the copper sheet may be diffused from the composite by way of these grooves. This diffusion of the gas is achieved particularly effectively by forming a plurality of grooves substantially parallel. These grooves are desired to have a width in the range of 0.01 to 3 mm, a pitch in the range of 1 to 25 mm, and a depth exceeding 0.01 mm and not exceeding 1/2 of the thickness of the copper sheet. All these dimensions are suitably selected, depending on the size of the copper sheet to be used.

Union of the ceramic substrate to the copper sheet is carried out, for example, as follows.

The copper sheet is disposed at a stated position on the ceramic substrate. The components, as held in the superposed state, are heated in a non-oxidizing atmosphere or, when the copper sheet is made of oxygen-free copper, in an oxidizing atmosphere containing a very small amount of oxygen, at a temperature in the range of 1,065 to 1,083°C, and preferably 1,070 to 1,075°C. The heating time is typically in the range of 2 to 30 minutes. After the heat is thus conducted the ceramic substrate and copper sheet are cooled to produce a joined ceramic-metal composite.

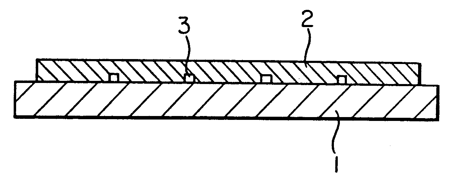

By way of example only the present invention will now be described with reference to the accompanying drawing which is a cross section illustrating one embodiment.

Now, the present invention will be described with reference to a working example.

### Example:

A crude alumina ceramic substrate was given a specular polishing with a diamond grindstone, #800, and then a whet honing to produce a ceramic substrate 1 measuring 35 mm in width, 55 mm in lenth, and 0.6 mm in thickness as illustrated in the drawing. The warp of this ceramic substrate 1 was 5.0 µm in the direction of length and 2.5 µm in the direction of width.

Separately, a plurality of parallel grooves 3 having a width of 0.3 mm, a pitch of 10 mm, and a depth of 0.1 mm were incised on the surface of a tough pitch copper sheet 2 measuring 30 mm in width, 50 mm in length, and 0.3 mm in thickness and having an oxygen content of about 300 ppm which was to be joined to the ceramic substrate 1. The ceramic substrate 1 and the copper sheet 2 were disposed as illustrated in the diagram, then heated in an atmosphere of nitrogen gas at a temperature of about 1,075°C for 3 minutes, and then cooled. The grooves were obtained by pressing edges of blades against the copper sheet.

The joined ceramic-metal composite obtained as described above was found to form substantially no blisters therein. The ratio of occurrence of blisters exceeding 4 mm in diameter was 0%.

A similar joined ceramic-metal composite of the conventional structure having no grooves formed in the interface of the layers was produced. In this composite, the ratio of occurrence of blisters exceeding 4 mm in diameter was in the range of 5 to 10%.

Since the joined ceramic-metal composite of this invention permits the oxygen gas emanating from the copper sheet to be released from the composite through the grooves, it can be prevented from producing blisters therein. Since blisters are liable to occur in the central part of the composite, the grooves may be formed in a radial pattern.

The frequency of the occurrence of blisters in the composite can be further decreased by using a ceramic substrate the warp of which is amply lower then the tolerable level.

## Claims

1. A method of forming a joined ceramic-metal composite which comprises a ceramic substrate (1) and a copper sheet (2) joined to one or each of the major surfaces of said ceramic substrate (1), said method comprising:
forming a plurality of grooves (3) in at least one major surface of said copper sheet for contacting one of the major surfaces of said ceramic substrate (1),
superposing the grooved major surface of said copper sheet (2) on one of the major surfaces of said ceramic substrate (1);
heating the superposed layers so as to directly join said ceramic substrate (1) to said copper sheet (2) by enabling any gas emanating from said ceramic substrate (1) or said copper sheet (2) to be vented by said grooves; and
cooling the hot composite consequently formed;
characterized by the steps, prior to the said superposition of the copper sheet on the substrate, of forming the grooves (3) by pressing edges of blades against said copper sheet (2); and specular polishing and then whet honing said ceramic substrate (1) to ensure said ceramic substrate (1) has a warp of no more than 20µ/50mm;
and in that the heating is at a temperature in the range of 1065° to 1083°C.

2. A method as claimed in claim 1 characterised by, before superposing said surfaces, oxidising said surface of said ceramic substrate (1) when said ceramic substrate (1) comprises a non-oxide type ceramic thereby reducing any gas which may emanate from the ceramic substrate during heating the layers.

3. A method as claimed in claim 1 or 2, in which said copper sheet (2) has an oxygen content initially in the range of 200 to 500 ppm, thereby reducing any gas which may emanate from the copper sheet during heating the layers.

4. A method according to claim 3, in which said plurality of grooves (3) on the grooved major surface of said copper sheet (2) are disposed substantially parallel to one another, each has a width in the range of 0.01 to 3 mm and a depth in the range of 0.01 to 0.1 mm but not more than half of the thickness of the copper sheet (2), and all are separated with a pitch of 1 to 25 mm.

5. A method as claimed in claim 4, in which said copper sheet (2) comprises tough pitch copper and has a thickness in the range of 0.03 to 0.5 mm.

6. A method as claimed in any one of claims 3 to 5, in which said composite forms a substrate for use in a transistor module.

## Patentansprüche

1. Verfahren zur Bildung eines zusammengesetzten metallkeramischen Verbundwerkstoffes mit einem keramischen Substrat (1) und einem Kupferblech (2), welches mit einer oder mit jeder der bedeutenderen Oberflächen des keramischen Substrates (1) verbunden ist, wobei das Verfahren folgende Schritte umfaßt:
Gestaltung einer Mehrzahl von Rillen (3) in wenigstens einer bedeutenderen Oberfläche des Kupferbleches im Hinblick auf die Kontaktherstellung mit einer der bedeutenderen Oberflächen des keramischen Substrates (1);
Überlagerung der gerillten bedeutenderen Oberfläche des Kupferbleches (2) auf eine der bedeutenderen Oberflächen des keramischen Substrates (1);
Heizen der übereinandergelagerten Schichten, so daß auf direktem Wege das keramische Substrat (1) mit dem Kupferblech (2) zusammengefügt wird, wobei man es jeglichem Gas, welches aus dem keramischen Substrat (1) oder aus dem Kupferblech (2) austritt, erlaubt mit Hilfe der Rillen ausgelüftet zu werden; und
Abkühlen des hierdurch gebildeten warmen Verbundwerkstoffes,
gekennzeichnet durch die, vor der Überlagerung des Kupferbleches auf das Substrat, durchgeführten Schritte der Gestaltung der Rillen (3) durch Anpressen von Kanten von Schneidewerkzeugen gegen das Kupferblech (2); sowie des spiegelartigen Polierens und des anschließenden Schleifabziehens des keramischen Substrates (1), um zu gewährleisten, daß das keramische Substrat (1) eine Verdrehung von nicht mehr als 20µ/50mm aufweist; und dadurch, daß das Heizen auf eine Temperatur in dem Bereich zwischen 1065 und 1083°C erfolgt.

2. Verfahren wie unter Anspruch 1 beansprucht, gekennzeichnet durch die vor der Übereinanderlagerung der Oberflächen stattfindende Oxydation der Oberfläche des keramischen Substrates (1), wenn das keramische Substrat (1) eine oxydfreie Keramikart aufweist, wodurch eine Verminderung jeglichen Gases, welches während des Heizens der Schichten aus dem keramischen Substrat austreten könnte, stattfindet.

3. Verfahren wie unter Anspruch 1 oder 2 beansprucht, bei welchem das Kupferblech (2) zu Anfang einen in dem Bereich zwischen 200 und 500 ppm liegenden Sauerstoffgehalt aufweist, wodurch eine Verminderung jeglichen Gases, welches während des Heizens der Schichten aus dem Kupferblech austreten könnte, stattfindet.

4. Verfahren gemäß Anspruch 3, bei welchem die Mehrzahl der Rillen (3) auf der gerillten bedeutenderen Oberfläche des Kupferbleches (2) im wesentlichen die eine parallel zu der anderen angeordnet sind, wobei eine jede eine Breite in dem Bereich zwischen 0,01 und 3 mm sowie eine Tiefe in dem Bereich zwischen 0,01 und 0,1 mm aufweist, jedoch nicht tiefer ist als die Hälfte der Dicke des Kupferbleches (2), und wobei alle durch eine in dem Bereich zwischen 1 und 25 mm liegende Entfernung voneinander getrennt sind.

5. Verfahren wie unter Anspruch 4 beansprucht, bei welchem das Kupferblech (2) ein Elektrolytzähkupfer aufweist mit einer Dicke in dem Bereich zwischen 0,03 und 0,5 mm aufweist.

6. Verfahren wie unter irgendeinem der Ansprüche 3 bis 5 beansprucht, bei welchem der Verbundwerkstoff ein für den Einsatz bei einem Transistormodul geeignetes Substrat bildet.

## Revendications

1. Procédé d'élaboration d'un matériau composite céramique-métal assemblé qui comprend un substrat céramique (1) et une feuille de cuivre (2) assemblée à l'une des surfaces ou à toutes les surfaces majeures dudit substrat céramique (1), ledit procédé comprenant les étapes de:
formation de plusieurs rainures (3) dans au moins une surface majeure de ladite feuille de cuivre en vue de l'établissement d'un contact avec l'une des surfaces majeures dudit substrat céramique (1);
superposition de la surface majeure rainurée de ladite feuille de cuivre (2) sur une des surfaces majeures dudit substrat céramique (1);
chauffage des couches superposées de façon à assembler directement ledit substrat céramique (1) avec ladite feuille de cuivre (2) en permettant à tout gaz émanant dudit substrat céramique (1) ou de ladite feuille de cuivre (2) d'être déchargé par lesdites rainures; et
refroidissement du matériau composite chaud ainsi formé;
caractérisé par les étapes, préalables à ladite superposition de la feuille de cuivre sur le substrat, de formation des rainures (3) en appliquant sous pression des tranchants de lames contre ladite feuille de cuivre (2); ainsi que de polissage spéculaire et ensuite de pierrage de repassage dudit substrat céramique (1), afin d'assurer audit substrat céramique (1) un gauchissement ne dépassant pas 20µ/50 mm; et en ce que le chauffage est effectué à une température variant dans la gamme de 1065 à 1083°C.

2. Procédé tel que revendiqué dans la revendication 1, caractérisé par l'oxydation, préalable à la superposition desdites surfaces, de ladite surface dudit substrat céramique (1), lorsque ledit substrat céramique (1) se compose d'une céramique du type sans oxyde, diminuant de cette façon tout gaz qui pourrait émaner du substrat céramique au cours du chauffage des couches.

3. Procédé tel que revendiqué dans la revendication 1 ou 2, dans lequel ladite feuille de cuivre (2) possède une teneur en oxygène initialement dans la gamme de 200 à 500 ppm, diminuant de cette façon tout gaz qui pourrait émaner de la feuille de cuivre durant le chauffage des couches.

4. Procédé selon la revendication 3, dans lequel lesdites plusieurs rainures (3) sur la surface majeure rainurée de ladite feuille de cuivre (2) sont pour l'essentiel disposées en parallèle l'une par rapport à l'autre, chacune possédant une largeur dans la gamme de 0,01 à 3 mm ainsi qu'une profondeur dans la gamme de 0,01 à 0,1 mm, qui n'est toutefois pas plus grande que la moitié de l'épaisseur de la feuille de cuivre (2), et toutes étant séparées par une distance de 1 à 25 mm.

5. Procédé tel que revendiqué dans la revendication 4, dans lequel ladite feuille de cuivre (2) se compose de cuivre à teneur en oxygène correctement ajustée et qu'il possède une épaisseur dans la gamme de 0,03 à 0,5 mm.

6. Procédé tel que revendiqué dans l'une quelconque des revendications 3 à 5, dans lequel ledit matériau composite constitue un substrat destiné à être mis en oeuvre dans un module de transistor.
